# EUROPÄISCHE PATENTANMELDUNG

(11) **EP 0 939 430 A2**
(43) Veröffentlichungstag der Anmeldung: **01.09.1999**
(21) Anmeldenummer: 98122835.6
(22) Anmeldetag: 01.12.1998
(51) Int. Cl.: H01L 21/285

(54) **Herstellverfahren für eine polykristalline Siliziumstruktur**

(30) Priorität: 25.02.1998 US 30406
(71) Anmelder: SIEMENS AKTIENGESELLSCHAFT, 80333 München (DE)
(72) Erfinder: Schrems, Martin Dr., 01465 Langebrück (DE); Morhard, Klaus-Dieter Dr., 01099 Dresden (DE); Wurster, Kai, 01099 Dresden (DE); Hoepfner, Joachim, 82152 Planegg (DE)

(57) **Zusammenfassung**

Es ist vorgesehen, zunächst eine primäre Siliziumstruktur in amorpher oder polykristalliner Form zu erzeugen und diese mit einem Dotierstoff, insbesondere mit Sauerstoff, in einer derartigen Konzentration zu dotieren, daß die Löslichkeitsgrenze überschritten ist. Bei einer nachfolgenden Temperaturbehandlung bilden sich Dotierstoffausscheidungen, die das Kornwachstum in der entstehenden sekundären (4, 16) steuern. Eine derartige Kontakt polykristallinen Siliziumstruktur ist insbesondere einsetzbar als Anschluß eines monokristallinen Siliziumgebietes.

## Beschreibung

Die Erfindung betrifft ein Herstellverfahren für eine polykristalline Siliziumstruktur mit definierter Korngröße auf einem Halbleitersubstrat

Bei der Herstellung von integrierten Schaltungen werden häufig polykristalline Siliziumstrukturen benötigt, und zwar insbesondere als elektrische Verbindungen zwischen Schaltungselementen, aber auch als Schaltungselemente (z.B. Kondensatorelektroden) selbst. Dabei ist die Kristallstruktur des Polysiliziums eine wichtige Eigenschaft. Sie beeinflußt beispielsweise die elektrische Leitfähigkeit, die Diffusion von Fremdstoffen, die Strukturierbarkeit zu schmalen Leitbahnen, Haftungseigenschaften usw., Einzelheiten dazu sind in Widmann, Mader, Friedrich, 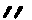 Technologie hochintegrierter Schaltungen", Kap. 3.8., Springer Verlag 1996, oder in Wolf, Tauber, 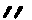 Silicon Processing" Vol.1, Ch.6, Lattice Press 1987 dargestellt. In der Halbleitertechnologie sind i.a. nur Polysiliziumschichten mit weitgehend konstanter Korngröße bzw. einer engen Korngrößenverteilung brauchbar.

Polysiliziumschichten werden üblicherweise durch einen CVD-Prozeß, wie er bsspw. in der oben angegebenen Literaturstelle von Widmann et al beschrieben ist, hergestellt. Die mittlere Korngröße und die Korngrößen verteilung kann durch das Temperaturbudget (Temperatur und Zeit) kontrolliert werden, wobei auch eine üblicherweise vorgenommenen Dotierung mit Bor, Phosphor, Arsen oder ähnlichem einen Einfluß auf die erzielte Korngrößenvertreilung hat.

Dotiertes polykristallines Silizium stellt häufig den elektrischen Anschluß eines monokristallinen Siliziumgebietes dar. Ein Beispiel hierfür ist ein Source- oder Drain-Gebiet eines MOS-Transistors, oder Emitter , Basis oder Kollektor eines Bipolartransistors. Das monokristalline Gebiet wird dabei meist von einem im Siliziumsubstrat erzeugten dotierten Siliziumgebiet gebildet. Die den elektrischen Anschluß bildende polykristalline Siliziumstruktur kann entweder aus einer polykristallinen Siliziumschicht erzeugt werden oder aus einer amorphen Siliziumschicht, die in späteren Verfahrensschritten polykristallin wird.

Bei nachfolgenden thermischen Schritten tritt eine Kristallisation bzw. eine Rekristallisation der amorphen bzw. polykristallinen Siliziumstruktur ein. Dabei ist zu berücksichtigen, daß die Grenzfläche zwischen dem monokristallinen Siliziumgebiet und der Siliziumstruktur meist ein dünnes Oxid aufweist oder anderweitig verunreinigt oder qualitätiv minderwertig sein kann. Dies kann zu unkontrollierter (Re-)kristallisation führen, d.h. räumlich stark schwankenden Korngrößen. Der dabei entstehende mechanische Streß kann durch Kristalldefektbildung im monokristallinen Silizium, wie beispielsweise Versetzungsbildung, abgebaut werden. Diese Kristalldefekte verschlechtern die elektrischen Eigenschaften des Substrats, beispielsweise durch einen erhöhten Leckstrom, es besteht also die Gefahr, daß im Substrat angeordnete Bauelemente oder aktive Strukturen (z.B. Transistoren, Grabenkondensatoren, p/n-Übergänge) nicht die vorbestimmten elektrischen Eigenschaften aufweisen, sondern bereits anfängliche Fehler oder auch mittel- und langfristige Qualitätseinbußen aufweisen.

Ein erstes Beispiel für einen derartigen Kontakt ist der Bitleitungskontakt in einem DRAM-Speicher , wobei der Speicherzelltyp beliebig sein kann (beispielsweise sogenannte stacked-Zelle oder Grabenzelle) . Ein weiteres Beispiel ist der Kondensatorkontakt in einer solchen Zelle, also der Kontakt zwischen der Speicherelektrode und dem Auswahltransistor, wobei das erläuterte Problem durch Kristalldefekte insbesondere bei Speicherzellen mit einem Grabenkondensator auftritt und in der DE-Patentanmeldung 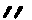 Kontakt zwischen einem monokristallinen Siliziumgebiet und einer polykristallinen Siliziumstruktur und Herstellverfahren für einen solchen Kontakt" derselben Erfinder und desselben Anmeldetags, sowie in der US-Patentanmeldung, Appl. No. 09/030 227 derselben Erfinder, Anmeldetag 25.2.98, im Einzelnen erläutert ist.

Der Erfindung liegt daher das allgemeine Problem zugrunde, ein Herstellverfahren für eine polykristalline Siliziumstruktur mit definierter Korngröße bzw. definierter Korngrößenverteilung anzugeben. Die polykristalline Siliziumstruktur soll als Anschluß für ein monokristallines Siliziumgebiet geeignet sein, ohne daß die erläuterten Probleme auftreten. Die Kristallstruktur soll durch eventuelle nachfolgende Temperaturbelastungen nicht wesentlich verändert bzw. verschlechtert werden.

Diese Aufgabe wird durch ein Herstellverfahren mit den Merkmalen des Anspruchs 1 gelöst.

Die Erfindung setzt eine Dotierung einer primären Siliziumstruktur, die nicht monokristallin ist, mit einem Dotierstoff aus der Gruppe Sauerstoff, Sauerstoff/StickstoffGemische, Sauerstoff/Stickstoff-Verbindungen, andere sauerstoffhaltige Gemische oder Verbindungen ein, wobei die Konzentration des Dotierstoffs (insbesondere des Sauerstoffs) so gewählt wird, daß die Löslichkeitsgrenze des Dotierstoffs überschritten ist (die genannten Dotierstoffe können auch als sauerstoffhaltige Dotierstoffe bezeichnet werden). Dadurch bilden sich bei nachfolgenden thermischen Schritten Dotierstoffausscheidungen in der primären Siliziumstruktur, gleizeitig wird die primäre Siliziumstruktur in eine polykristalline sekundäre Siliziumstruktur durch Kristallisation bzw. Rekristallisation umgewandelt. Dabei lassen die Dotierstoffausscheidungen das Kornwachstum in der sekundären Siliziumstruktur nur bis zu einer bestimmten Größe zu. Diese Korngröße wird durch die Dichte (d.h. den mittleren Abstand) der Dotierstoffausscheidungen bestimmt. Die Dotierstoffausscheidungen haben also quasi eine Käfigwirkung. Je höher die Dichte der Dotierstoffausscheidungen ist, desto geringer ist die maximale und die mittlere Polysilizium-Korngröße in der Siliziumstruktur. Die mittlere Anzahl (d.h. die Dichte) der Dotierstoffausscheidungen wird durch die Dotierstoffübersättigung (Dotierstoffkonzentration dividiert durch die Löslichkeitskonzentration) und das thermische Budget (ramp-Raten, Haltetemperaturen) bei den nachfolgenden thermischen Behandlungen kontrolliert. Auch die Co-Dotierung anderer Stoffe wie z.B. As, P, Sb, N, B kann die Bildung von sauerstoffhaltigen Ausscheidungen verzögern (As, P) oder beschleunigen (B).

Dient die erfindungsgemäß hergestellte Polysiliziumstruktur als Ahschluß für ein monokristallines Siliziumgebiet, so wird die Kristalldefektbildung im Monosilizium vermieden, da die unkontrollierte (Re-)kristallisation in der Siliziumstruktur unterbleibt. Gleichzeitig wird ein niedriger Übergangswiderstand zwischen der polykristallinen Siliziumstruktur und dem monokristallinen Siliziumgebiet erzielt.

Als Dotierstoff ist insbesondere Sauerstoff geeignet, da aufgrund der niedrigen Löslichkeit des Sauerstoffs Ausscheidungen besonderns leicht gebildet werden. Es ist also keine hohe Dotierung notwendig. Die Leitfähigkeit der Silizium-Struktur oder des Silizium-Gebietes wird nicht entscheidend vermindert. Sauerstoffausscheidungen liegen dann als SiOₓ mit x ≈ 2 vor.

Die Dichte der Dotierstoffausscheidungen beträgt etwa 10¹⁵ bis 10¹⁹ cm⁻³.

Als Dotierverfahren können insbesondere Ionen-Implantation, Plasma-Doping oder Plasma Immersion Ion Implantation (PIII) eingesetzt werden. Diese Verfahren sind dem Fachmann geläufig und beispielsweise in den US-Patentschriften 5,354,381 und 4,937,205 näher erläutert. Bei Plasma-Doping kann die Dosis besonders gut kontrolliert werden. Die Dotierung kann so erfolgen, daß der Dotierstoff in der Siliziumstruktur gleichmäßig verteilt wird, d.h. eine im wesentlichen überall gleiche Dotierstoff-Konzentration vorliegt, die über der Löslichkeitsgrenze liegt. Andererseits kann ein Dotierstoff-Maximum in einem vorbestimmten Teil des Siliziumgebietes oder der Siliziumstruktur erzeugt werden, beispielsweise in der Nähe des Kontaktes oder in einer vorgegebenen Tiefe. Ferner kann auch eine Dotierung eines kontaktnahen Gebietes des Monosiliziums anstelle oder zusätzlich zur Siliziumstruktur erfolgen. Es entstehen dann Dotierstoffausscheidungen im monokristallinen Silizium in der Nähe des Kontaktes, die als Barriere gegen Ausbreitung von Versetzungen aus dem polykristallinen Silizium wirken.

Die Siliziumstruktur kann auch in situ , also während der CVD-Abscheidung, dotiert werden. Dazu kann ein Verfahren entsprechend der bekannten In-Situ-Dotierung eingesetzt werden.

Die Konzentration des Dotierstoffs im Silizium liegt im Bereich 10¹⁷ bis 10²¹ cm⁻³ , vorzugsweise im Bereich 10¹⁹ bis 10²⁰ cm⁻³ .

Weitere Einzelheiten zur Herstellung der polykristallinen Siliziumstruktur sind in der US-Patentanmeldung 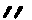 Kontakt zwischen einem monokristallinen Siliziumgebiet und einer polykristallinen Siliziumstruktur und Herstellverfahren für einen solchen Kontakt" desselben Anmelders und derselben Erfinder mit demselben Anmeldetag beschrieben, deren Gesamtoffenbarung hier miteinbezogen wird.

Die Erfindung wird im folgenden anhand eines in den Figuren dargestellten Ausführungsbeispiels näher beschrieben. Es zeigen
FIG 1, 2: Einen Querschnitt durch ein Halbleitersubstrat mit einem monokristallinen Siliziumgebiet, an dem ein Ausführungsbeispiel der Erfindung verdeutlicht wird,
FIG 3 - 5: Einen Querschnitt durch ein Halbleitersubstrat mit einem monokristallinen Siliziumgebiet, an dem ein weiteres Ausführungsbeispiel der Erfindung verdeutlicht wird, wobei Fig 4 das dabei erzielte Dotierstoffprofil zeigt.

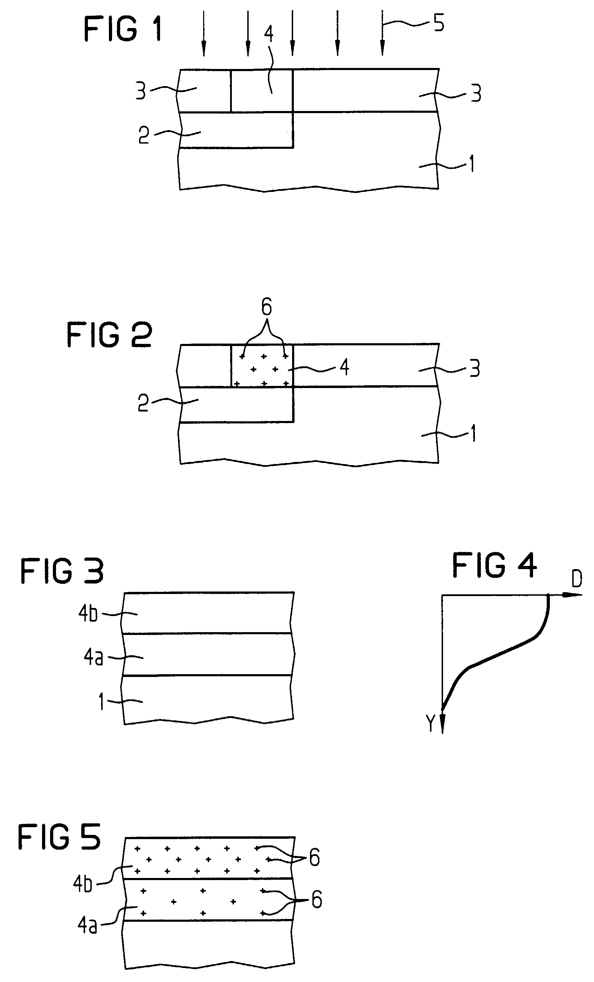

FIG 1: Ein Siliziumsubstrat 1 weist an seiner Oberfläche ein dotiertes monokristallines Gebiet 2 auf, das beispielsweise ein Sourcegebiet eines MOS-Transistors sein kann. Auf dem dotierten monokristallinen Gebiet 2 ist eine primäre Siliziumstruktur 4 angeordnet, die nicht monokristallin ist, sondern beispielsweise polykristallin, und durch einen Abscheideprozeß erzeugt wurde.Es kann aber auch eine amorphe primäre Siliziumstruktur verwendet werden. Übrige Bereiche der Anordnung sind mit einer Isolation 3 versehen. Erfindungsgemäß wird diese Polysiliziumstruktur 4 mit einem Dotierstoff, beispielsweise Sauerstoff dotiert. Die Dotierung kann beispielsweise durch eine vertikale Ionenimplantation erfolgen. Die Implantation kann ganzflächig ausgeführt werden, wenn dies mit der übrigen Halbleiterschaltung kompatibel ist. Dabei werden die Implantationsparameter so gewählt, daß die Dotierstoffkonzentration in der Polysiliziumstruktur 4 die Löslichkeitsgrenze überschreitet. Im Fall einer Sauerstoffdotierung beträgt die Konzentration des Doierstoffs in der primären Si-Struktur vorzugsweise 10¹⁷ bis 10²¹ cm⁻³ , insbesondere liegt sie im Bereich 10¹⁸ bis 10²⁰ cm⁻³. Beispielsweise wird bei einer 300 nm dicken Polysiliziumschicht 4 eine Dosis von 3 bis 5 x 10¹³ cm⁻² bei einer Energie von etwa 5 keV gewählt.

FIG 2: Anschließend wird ein Temperaturschritt durchgeführt, beispielsweise 30 min bei 900-1000° C, wodurch Dotierstoffausscheidungen 6, hier Si0ₓ-Ausscheidungen, in der Polysiliziumstruktur 4 gebildet werden. Diese begrenzen, wie oben erläutert, das Kornwachstum in der Siliziumstruktur (Käfigwirkung), es wird eine enge Korngrößenverteilung im sekundären polykristallinen Silizium erzielt. Die Ausbreitung von Kristallfehlern in das dotierte Gebiet 2 und in das Substrat 1 (FIG 2) wird verhindert.

Die Dotierung kann auch durch ein anderes Verfahren erfolgen bapw. Sauerstoff-Plasmadoping (Zeit: 10 sec, Energie 1 keV bei der angegebenen Schichtdicke).

Anstelle der gleichmäßigen Dotierung kann ein ein lokales Dotierstoffmaximum an einer vorgegebene Stelle erzeugt werden, bspw. durch eine schräge Implantation. Eine weitere Möglichkeit besteht darin, das Maximumin einer vorgegebenen Tiefe der Siliziumstruktur zu erzeugen. Dies ist besonders günstig , wenn wie in der Figur ein Kontakt zu einem unterliegenden Substrat erzeugt werden soll, das Dotierstoffmaximum wird dann in die Nähe der Substratoberfläche gelegt. Dazu wird zunächst lediglich eine dünne Si-Struktur als Teil der primären Siliziumstruktur auf der Substratoberfläche erzeugt, bspw. indem eine 30 nm dicke amorphe Siliziumschicht abgeschieden wird. Diese wird dotiert, dann wird Silizium in der benötigten Restdicke aufgebracht und der Temperaturschritt durchgeführt.

FIG 3: In diesem Ausführungsbeispiel wird die primäre Siliziumstruktur in zwei Teilstrukturen 4a, 4b aufgebracht, wobei zunächst eine undotierte a-Si- oder poly-Si-Schicht 4a und dann eine hochdotierte a-Si- oder poly-Si-Schicht 4b auf dem Substrat aufgebracht werden. Beide Teilschichten können bspw. mittels CVD aufgebracht werden. Wie im ersten Beispiel wird ein Temperaturschritt durchgeführt.

FIG 4 zeigt die Abhängigkeit der Dotierstoffkonzentration D von der Tiefe y.

Fig 5: Nach der Temperaturbehandlung sind in den Teilschichten 4a, 4b Dotierstoffausscheidungen gebildet, deren Dichte in der höher dotierten Teilschicht 4b größer ist als in 4a. Die in der höher dotierten Teilschicht 4b erzielte Korngröße ist daher geringer als in 4a.

Die Teilschichten können auch so angeordnet sein, daß die höher dotierte unterhalb der niedriger dotierten liegt.

Mit der Erfindung kann auch eine Polysiliziumschicht definierter Korngröße ohne Kontakt zum monokristallinen Substrat hergestellt werden. Es kann eine Polysiliziumschicht ganzflächig abgeschieden werden, mit Sauerstoff über die Löslichkeitgrenze dotiert werden und dann zu Leitbahnen oder anderen Strukturen strukturiert werden.

In vielen Fällen wird die polykristalline Siliziumstruktur zusätzlich nach bekannten Vefahren mit einem Dotierstoff des N- oder p-Leitfähigkeitstyps dotiert werden, um eine gewünschte Leitfähigkeit zu erreichen. Diese zussätzliche Dotierung erfolgt bevorzugt in einem in-situ-Verfahren bei der Abscheidung. Da die (Re-)kristallisation einer Polysiliziumschicht auvh durch die Dotierung beeinflußt wird, sind die erfindungsgemäße Dotierung und die Temperaturbehandlung darauf abzustimmen.

## Patentansprüche

1. Herstellverfahren für eine polykristalline Siliziumstruktur (4, 16) mit definierter Korngröße auf einem Substrat mit folgenden Schritten:
- Erzeugen einer primären Siliziumstruktur (4, 16) in amorpher oder polykristalliner Form auf dem Substrat,
- Dotieren der primären Siliziumstruktur (4, 16) mit einem sauerstoffhaltigen Dotierstoff in einer derartigen Konzentration, daß die Löslichkeitsgrenze des Dotierstoffs in der Siliziumstruktur oder dem Siliziumgebiet überschritten ist,
- Durchführen einer Temperaturbehandlung, so daß Dotierstoffausscheidungen (6, 18) in vorbestimmter Dichte in der Siliziumstruktur (4, 16) gebildet werden und eine Kristallisation oder Rekristallisation der Siliziumstruktur (4, 16) stattfindet, wobei die mittlere /maximale Korngröße der dabei entstehenden sekundären Siliziumstruktur durch die Dichte der Dotierstoffausscheidungen vorbestimmt ist.

2. Verfahren nach Anspruch 1, bei dem eine Dotierstoffkonzentration im Bereich von 10¹⁷ bis 10²¹ cm⁻³ in der primären Siliziumstruktur erzeugt wird.

3. Verfahren nach einem der Ansprüche 1 bis 2, bei dem die Siliziumstruktur bei der Temperaturbehandlung auf 700 bis 1100°C erwärmt wird.

4. Verfahren nach einem der Ansprüche 1 bis 3, bei dem die Dichte der Dotierstoffausscheidungen in der sekundären Siliziumstruktur im Bereich 10¹⁵ bis 10¹⁹ cm-³ liegt.

5. Verfahren nach einem der Ansprüche 1 bis 4, bei dem die Siliziumstruktur zwecks Erzeugung einer n- oder p-Leitfähigkeit zusätzlich mit einem Dotierstoff des n- oder p-Leitfähigkeitstyps dotiert wird.

6. Verfahren nach einem der Ansprüche 1 bis 5, bei dem die Siliziumstruktur (4, 16) räumlich homogen dotiert wird.

7. Verfahren nach einem der Ansprüche 1 bis 5, bei dem die Siliziumstruktur (4, 16) räumlich inhomogen dotiert wird.

8. Verfahren nach Anspruch 7, bei dem das Maximum der Dotierstoffverteilung in einer vorgegebenen Tiefe der Siliziumstruktur (4, 16) gebildet wird.

9. Verfahren nach einem der Ansprüche 1 bis 8, bei dem die Sliziumstruktur angrenzend an ein monokristallines Siliziumgebiet (2) erzeugt wird und als elektrischer Anschluß des Siliziumgebietes verwendet wird.

10. Polykristalline Siliziumschicht, herstellbar durch ein Verfahren nach einem der vorstehenden Ansprüche.
